# EUROPÄISCHE PATENTSCHRIFT

(11) **EP 0 880 421 B1**
(45) Veröffentlichungstag und Bekanntmachung des Hinweises auf die Patenterteilung: **27.12.2000**
(21) Anmeldenummer: 97905007.7
(22) Anmeldetag: 10.02.1997
(51) Int. Cl.: B23K 20/10

(54) **VERFAHREN ZUM BONDEN VON ISOLIERDRAHT UND VORRICHTUNG ZUR DURCHFÜHRUNG DES VERFAHRENS**
METHOD OF BONDING INSULATING WIRE AND DEVICE FOR CARRYING OUT THIS METHOD
PROCEDE PERMETTANT D'EFFECTUER LE BONDING D'UN FIL ISOLANT ET DISPOSITIF DE MISE EN OEVRE DUDIT PROCEDE

(30) Priorität: 12.02.1996 DE 19605038
(43) Veröffentlichungstag der Anmeldung: 02.12.1998
(73) Patentinhaber: DaimlerChrysler AG, 70567 Stuttgart (DE); AEG Identifikationssysteme GmbH, 89077 Ulm (DE)
(72) Erfinder: KEMPE, Wolfgang, D-64546 Mörfelden-Walldorf (DE)
(74) Vertreter: Maute, Hans-Jürgen, Dipl.-Ing.
(86) Internationale Anmeldenummer: EP9700596
(87) Internationale Veröffentlichungsnummer: WO9728922

(56) Entgegenhaltungen:
- EP-A- 0 106 716
- EP-A- 0 286 031
- EP-A- 0 421 018
- DE-A- 2 161 023
- US-A- 4 778 097
- US-A- 4 821 944
- US-A- 4 950 866
- US-A- 5 192 015
- US-A- 5 240 166
- IEEE TRANSACTIONS ON COMPONENTS,HYBRIDS,AND MANUFACTURING TECHNOLOGY, Bd. 12, Nr. 4, 1.Dezember 1989, Seiten 603-608, XP000102505 SUSUMU OKIKAWA ET AL: "DEVELOPMENT OF A COATED WIRE BONDING TECHNOLOGY"

## Beschreibung

Die Erfindung betrifft ein Verfahren zum elektrisch leitfähigen Verbinden von lackisolierten Drähten sowie eine Vorrichtung zur Durchführung des Verfahrens gemäß den unabhängigen Ansprüchen.

Zur Herstellung von Identifikationssystemen, insbesondere Transpondern, werden Sender/Empfänger-Einheiten mit Logikschaltungen in integrierten Schaltkreisen (Chips) gekoppelt. Das System ist mit der Außenwelt durch Spulen verbunden, die im Radiofrequenzbereich arbeiten und die aus dünnen, mit Polyurethanlack-Überzug isolierten Kupferdrähten gewickelt sind. Typische Drahtdurchmesser liegen bei etwa 10-50 µm. Zum Verbinden derartiger elektronischer Bauelemente mit Halbleiterchips kommen Verfahren wie z.B. das Thermokompressions-Schweißverfahren zum Einsatz, bei dem die Kupferdrahtenden mit den metallisierten Chipkontaktflächen verbunden werden. Bei diesem Verfahren wird der Draht jedoch stark deformiert, wodurch der Gefahr des Abreißens entsteht. Ein lackisolierter Draht wird vor dem elektrischen Verbinden zuerst abisoliert, insbesondere mittels Mikro-Fräsern oder überhitzten Lötbädern, anschließend verzinnt und dann auf die Chip-Kontaktflächen aufgebondet. Übliche Chip-Kontaktflächen bestehen häufig aus Aluminiumdünnfilmen, die in einem zusätzlichen Prozeßschritt zum Ankontaktieren der Kupferdrähte einem sogenannten Gold-Bump-Verfahren unterzogen worden sind, um die Aluminiumfläche lötbar zu machen und so eine Haftung zwischen den unterschiedlichen Werkstoffen zu ermöglichen.

Derartige Transponder sind z.B. aus WO-A-93 09551 bekannt. In der Schrift ist offenbart, die lackisolierten Drähte und die Chipkontaktflächen mit einem Laserschweißverfahren zu verbinden. Dazu werden die Drahtenden vor dem Verbinden mit einem Laserstrahl erhitzt, der Lack geschmolzen und verdampft. Zur zuverlässigen Kontaktierung ist es notwendig, die Chipkontaktflächen zu vergolden und/oder zu verzinnen. Es erweist sich als vorteilhaft, auch die Drahtenden zu verzinnen. Der Draht wird zwar nur wenig oder gar nicht deformiert, so daß ein Abreißen des Drahtes vermieden werden kann, jedoch ist dadurch die Kontaktfläche nicht optimal ausgenutzt. Zudem ist eine Anzahl von aufwendigen Prozeßschritten notwendig. Zusätzlich kann die elektrische Verbindung durch am Drahtende verbliebene geschmolzene oder das Drahtende kontaminierende verdampfte Lackreste verschlechtert werden

Aus der JP-A-2-112249 ist ein Verfahren bekannt, lackisolierte Drähte mit Ultraschallbonden zu verbinden. Zuerst wird das Drahtende abisoliert und dann auf die Verbindungsfläche unter gleichzeitiger Einwirkung von Ultraschall und Wärme aufgebondet. Das Abisolieren erfolgt auf einer der Verbindungsfläche benachbarten Fläche, welche eine waschbrettartige Oberflächenstruktur aufweist. Dort wird das Drahtende unter Ultraschalleinwirkung wie auf einem Reibeisen abgeschmirgelt, bis der metallische Draht zum Vorschein kommt und anschließend auf die eigentliche Verbindungsfläche hinübergezogen. Eine ähnliches Verfahren ist auch aus der JP-A-2-54947 desselben Anmelders bekannt. Der Nachteil einer Verunreinigung der Verbindungsfläche durch verkohlte Lackreste wird zwar vermieden, die Fertigung der Reibflächen an jeder Verbindungsfläche ist technologisch jedoch sehr aufwendig. Zudem stellt die im Verfahren notwendige Wärmeeinwirkung zur Herstellung einer dauerhaften elektrischen Verbindung eine unerwünschte Belastung des Bauelements dar.

Die üblichen Verfahrensweisen bestehen aus einer Reihe von technisch und zeitlich aufwendigen und teuren Prozeßschritten, die die Produktionskosten erhöhen.

Aus der JP-A-6-61313 ist ein Bondwerkzeug bekannt, das besonders zum Ultraschallbonden geeignet ist. Mit einem derartigen Werkzeug gebondete Drähte weisen jedoch häufig nur partiell eine Verbindung zur Kontaktfläche auf.

In der DE-A-21 61 023 ist ein Bondverfahren offenbart, bei dem Drähte mit Ultraschall auf Kontaktflächen gebondet werden. Dabei wird der Draht zuerst mit einem Ultraschall-Vorimpuls auf der Kontaktfläche fixiert und dann mit einem stärkeren Puls mit der Kontaktfläche verschweißt. Der Draht weist danach starke Deformationen auf, wobei dessen Dicke im bearbeiteten Bereich nur noch etwa 30% des ursprünglichen Durchmessers beträgt. Eine etwaige Oxidschicht oder eine Isolierbeschichtung des Drahtes wird dabei sowohl an der Oberseite als auch auf der Kontaktseite aufgebrochen. Die Drahtoberseite ist ungeschützt und Isolierreste können an der Kontaktfläche verbleiben.

Der Erfindung liegt daher die Aufgabe zugrunde, ein kostengünstiges und zuverlässiges Bondverfahren für lackisolierte Drähte, das ohne zusätzliche Metallisierung der Kontaktflächen auskommt, sowie eine Vorrichtung zur Durchführung des Verfahrens anzugeben.

Die Aufgabe wird durch die Merkmale der unabhängigen Ansprüche gelöst. Weiterführende und vorteilhafte Ausgestaltungen sind den Unteransprüchen und der Beschreibung zu entnehmen.

Die Erfindung besteht darin, lackisolierte Drähte mit einem zweistufigen Bondverfahren direkt auf die elektrischen Kontaktflächen eines Chips aufzubonden. In einem ersten Prozeßschritt wird der Lackschicht des Drahtes aufgebrochen und dann anschließend in einem zweiten, anschließenden Schritt mit der Verbindungsfläche verbunden. Bevorzugt wird die Lackschicht an der Unterseite des Drahtes, welche mit der Verbindungsfläche in Kontakt kommen soll, aufgebrochen, ohne daß die Lackschicht an der Drahtoberseite geschädigt wird.

Eine besonders bevorzugte Ausführungsform des Verfahrens besteht darin, beide Prozessschritte mit Ultraschall auszuführen.

Der Vorteil des Verfahren besteht darin, daß eine zuverlässigen Kontaktierung erreicht wird, ohne einen vorausgehenden Prozeßschritt des separaten Abisolierens und Verzinnens des Drahtendes oder eines aufwendigen Vergoldens oder Gold-Bump-Verfahrens für die Kontaktflächen des Chips durchführen zu müssen. Im Gegensatz zu Verfahren, bei denen die Lackschicht rundum entfernt wird, wird nur die Lackschicht an der Unterseite entfernt. Die verbleibende Lackschicht kann die Verbindung dauerhaft gegen Korrosion schützen, ohne die elektrische Verbindung selbst zu verschlechtern.

Vorteilhaft ist außerdem, daß die Belastung im Verbindungsbereich zwischen Draht und Kontaktfläche stark verringert wird, da zum einen eine Wärmeeinwirkung beim Ultraschall-bonden nicht mehr notwendig ist, zum anderen die erzeugte Deformation des Drahtes für einen optimalen Kontaktwiderstand groß genug, aber gering genug ist, um ein Abreißen des Drahtes zu verhindern.

Das Verfahren wird in zwei Stufen am gleichen Drahtende ausgeführt und im wesentlichen auf derselben Stelle der Verbindungsfläche. Eine aufwendige Verschiebeeinheit des Ultraschallwerkzeugs zum Verschieben des Drahtendes während des Verbindungsvorganges ist nicht notwendig.

Das Verfahren kann mit herkömmlichen Bondmaschinen durchgeführt werden, die in geringem Umfang modifiziert sind. Vorteilhaft ist es, spezielles Bondwerkzeug zu verwenden, das einfach aufgebaut und in üblichen Bondmaschinen verwendet werden kann, da herkömmliches Bondwerkzeug zum Führen von losen Drahtenden von Bauelementen nicht geeignet ist.

In einer bevorzugten Ausführungsform ist das Bondwerkzeug so gestaltet, daß es das Ablösen der Lackisolierung an der Drahtunterseite, welche den elektrischen Kontakt herstellen soll, unterstützt, ohne die Lackfläche an der Drahtoberseite zu beschädigen und gleichzeitig vorteilhaft den Draht so deformiert, daß eine optimale Drahtfläche mit der elektrischen Kontaktfläche in Kontakt kommen kann.

Im ersten Prozeßschritt kann auch trotz der Lackisolierung des Drahtes eine Schmelzkugel am Drahtende erzeugt werden, um einen sogen. 'ball-wedge'-Kontakt herzustellen. Die dauerhafte Verbindung erfolgt im zweiten Prozeßschritt.

Im folgenden sind die Merkmale, soweit sie für die Erfindung wesentlich sind, eingehend erläutert und anhand von Figuren näher beschrieben. Es zeigen
- Fig. 1a: ein Bondwerkzeug für eine wedge-wedge-Bondvorrichtung
- Fig. 1b: eine Ansicht der Unterseite des Bondwerkzeugs
- Fig. 1c: den Schnitt durch zwei Verbindungen
- Fig. 2: eine Bondkapillare, insbesondere für ball-wedge-Bondvorrichtungen
- Fig. 3: eine Bondkapillare mit Einfädelhilfe, insbesondere für ball-wedge-Bondvorrichtungen

Zur Herstellung eines elektrischen Kontaktes zwischen Bauelementen, z. B. Spulen und anderen Wickelgütern, und einem Halbleiterchip muß zunächst die Isolierung der Lackschutzschicht, die einen etwaigen Windungsschluß im Bauelement verhindern soll, durchbrochen werden.

Dies kann mittels elektromagnetischer Energie wie Wärme, Mikrowellen - vorzugsweise bei einem wasserhaltigen Lack - oder akustischer Energie, z.B. Ultraschall mit einer Frequenz oberhalb von 50 kllz, erfolgen. Zumindest ein Teil der eingestrahlten Energie wird in der Lackschicht absorbiert und zerstört dort den Lack, bzw. bei Einwirken von Wärme wird der Lack lokal verbrannt.

Im folgenden ist ein sogenanntes wedge-wedge-Bondverfahren beschrieben. In einer bevorzugten Ausführungsform wird das Verfahren mit Ultraschalleinwirkung durchgeführt.

Übliche Ultraschalleistungen beim Ultraschallbonden nach dem Stand der Technik liegen bei ca. 2 Watt, übliche Anpreßkräfte etwa bei 0,2-0,3 N.

In einem ersten erfindungsgemäßen Prozeßschritt wird mit einer ersten Ultraschalleistung, die höher ist als die zum üblichen Ultraschall-Bonden verwendete Leistung, die Lackschicht durchbrochen. Zudem wird der Draht mit einer ersten Anpreßkraft auf die elektrische Kontaktfläche gedrückt. Bevorzugt ist kann die erste Anpreßkraft von Null bis zu einem Wert variieren, welcher höher ist als üblich. Die erste Ultraschalleistung übersteigt die übliche Leistung von ca. 2 Watt vorzugsweise um mindestens 20%, besonders bevorzugt liegt sie zwischen 4 und 5 Watt.

Die erste Anpreßkraft ist bevorzugt höher, besonders bevorzugt um etwa eine Größenordnung höher als die übliche Anpreßkraft von 0,2-0,3 N beim Bonden, vorzugsweise beträgt sie mehr als 1 N. Die Lackschutzschicht an der Drahtunterseite wird dabei so stark geschädigt, daß der metallische Draht zum Vorschein kommt. Die Reste der durchbrochenen Lackschicht werden dabei zuverlässig an die Flanken des aufzubondenden Drahtstückes geschoben. Gegebenenfalls können die Lackreste entfernt, insbesondere abgesaugt werden.

In einem zweiten, direkt anschließenden Prozeßschritt wird das Drahtende mit einer zweiten Anpreßkraft, bevorzugt einer geringeren Anpreßkraft als beim ersten Schritt, an die Kontaktfläche gepreßt. Die Anpreßkraft muß jedoch groß genug sein, um den mechanischen Widerstand durch die Lackreste, die sich jetzt an den Flanken des Drahtstückes befinden, zu überwinden. Für übliche Drahtstärken um ca. 50µm Durchmesser liegt die zweite Anpreßkraft bevorzugt im Bereich von 0,1 bis 5 N, besonders bevorzugt von 0,5 bis 1,5 N. Es ist zweckmäßig, die zweite Anpreßkraft für andere Drahtstärken zu optimieren. Die Ultraschalleistung und die Anpreßkräfte wirken im ersten und zweiten Prozeßschritt jeweils auf denselben Bereich des Drahtendes und denselben Bereich der Kontaktfläche ein.

Die Ultraschalleistungen und die Anpreßkräfte sind insgesamt wesentlich höher als bei üblichen Ultraschallbondverfahren, bleiben aber in beiden Prozeßschritten gering genug, um die Chipkontaktfläche nicht zu schädigen. Während die der Kontaktfläche zugewandte Unterseite der Lackschicht zuverlässig aufgebrochen und beseitigt wird, bleibt die Oberseite der Lackschicht dagegen im wesentlichen intakt und schützt die Verbindung gegen Korrosion.

Nach diesen beiden Prozeßschritten ist die elektrische Verbindung zwischen dem Bauelement, insbesondere einer Spule, und Chip-Kontaktfläche dauerhaft hergestellt. Die Haltekräfte zwischen Draht und Kontaktfläche sind vergleichbar mit üblichen kaltverschweißten Verbindungen. Die Belastung des Verbindungsbereiches zwischen Drahtende und Kontaktfläche sowie die Deformation des Drahtendes ist jedoch wesentlich geringer als bei einem Thermokompressions-Verfahren.

Das Verfahren kann mit einfachen Veränderungen an den Bondmaschinen durchgeführt werden, und wird bevorzugt mit Bondmaschinen ausgeführt, die Ultraschalleistungen und Anpreßkräfte bis zur gewünschten Höhe von vorzugsweise etwa 10 W und 5 N zur Verfügung stellen.

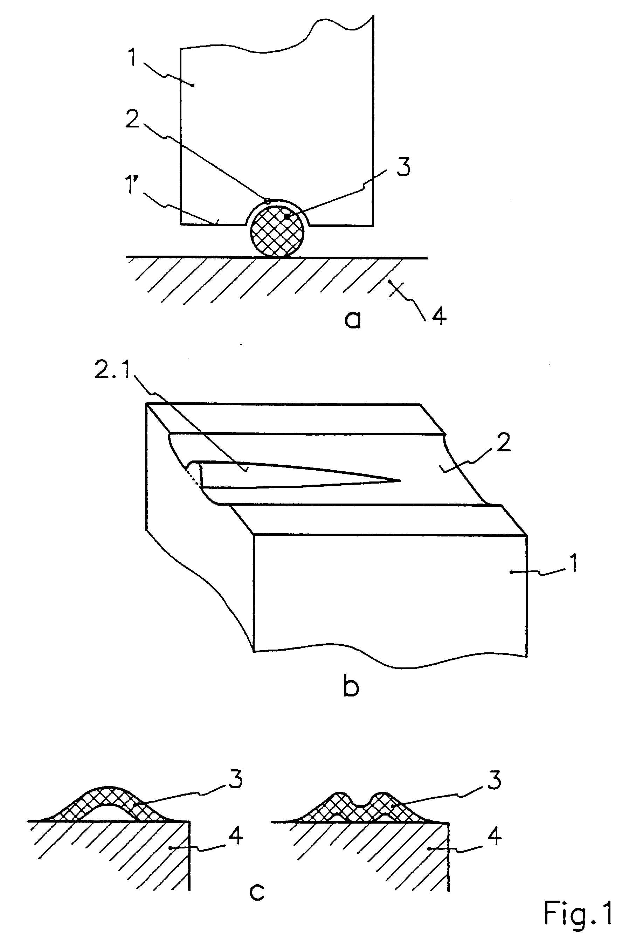

Besonders vorteilhaft ist es, daß das Bondwerkzeug vereinfacht werden kann, wie in Fig. 1 dargestellt ist. Anstatt der üblichen aufwendigen Konstruktion mit einer schrägen Durchbohrung des in etwa zylinderförmigen. Werkzeugs in einem Winkel zwischen typischerweise 30° und 60° und einer Drahtumlenkung, die einen in die Bohrung eingeführten Bonddraht an der Unterseite des Werkzeugs parallel zur Kontaktfläche führt, wird ein einfacheres Bondwerkzeug 1 verwendet, dessen Unterseite 1' eine längliche, konkave Einkerbung 2 aufweist, die dem Drahturchmesser angepaßt ist (Fig. 1a). Vorzugsweise ist die Einkerbung 2 geformt wie ein aufgeschnittener Zylinder, parallel zu dessen Mittelachse der Draht 3 geführt wird. Die Tiefe der Einkerbung ist dabei geringer als der jeweilige Drahtdurchmesser.

Besonders vorteilhaft ist, daß das Bondwerkzeug 1 somit im Horizontalen arbeitet und eine aufwendige Einfädelprozedur der an sich ungeführten Drahtenden 3, z.B. einer Spule, entfällt und trotzdem die Drahtenden 3 beim Bonden sicher geführt und auf die Kontaktfläche 4 gepreßt werden.

In einer besonders bevorzugten Ausführungsform wird das Bondwerkzeug 1 so geformt, daß es das Aufbrechen und Wegschieben der Lackschicht an der Drahtunterseite, welche den elektrischen Kontakt herstellen soll, unterstützt, ohne die Lackfläche an der Drahtoberseite zu beschädigen. Gleichzeitig wird der Draht vorteilhaft so deformiert, daß eine möglichst große Drahtfläche mit der elektrischen Kontaktfläche in Kontakt kommen kann, ohne daß die Gefahr besteht, den Draht so stark zu deformieren, daß er abreißt. Dies ist in Fig. 1b dargestellt. Entlang der Scheitellinie der konkav geformten Einkerbung 2 ist eine Ausstülpung 2.1 ausgebildet, die dem Drahtende zugewandt ist. Die Höhe der Ausstülpung 2.1 ist geringer als die der Einkerbung 2. Die Ausstülpung ist länglich geformt und verläuft längs der Scheitellinie der Einkerbung 2. Bevorzugt läuft die Ausstülpung in spitzen Enden aus.

In Fig. 1c ist ein schematischer Vergleich zweier typischer Schnittbilder von gebondeten Drahtenden gezeigt, welche mit dem bekannten und dem erfindungsgemäßen Werkzeug hergestellt wurden. Das mit dem bekannten Werkzeug gebondete Drahtende 3 ist im wesentlichen im Randbereich mit der Kontaktfläche 4 verbunden. Der innere Bereich des Drahtendes 3 ist nicht in Kontakt mit der Kontaktfläche 4. Das mit dem erfindungsgemäßen Werkzeug gebondete Drahtende 3 weist dagegen sowohl im Randbereich als auch im inneren Bereich Kontakt mit der Kontaktfläche 4 auf. An der Oberfläche des Drahtendes ist durch die Ausstülpung 2.1 eine Mulde eingeprägt. Beim Bondvorgang unterstützt der zusätzliche Druck der Ausstülpung auf den Drahtscheitel das Aufbrechen der Lackschicht an der Drahtunterseite und das Wegschieben der Lackreste an den Drahtrand. Lediglich kleine Flächenbereiche nahe der Muldenflanken sind nicht in Kontakt mit der Kontaktfläche 4.

Eine weitere Variante des erfindungsgemäßen Verfahrens betrifft ein ball-wedge-Bandverfahren. Bei den üblichen ball-wedge-Verfahren wird ein Drahtende, das in eine Bondkapillare eingelegt ist, durch eine Funkenentladung aufgeschmolzen. Die so entstandene Schmelzkugel wird auf die gewünschte Kontaktfläche mit Ultraschall aufgebondet. Dieses Verfahren bedingt jedoch eine durchgehend leitfähige Verbindung zum Draht und kann daher mit lackisolierten Drähten nicht durchgeführt werden.

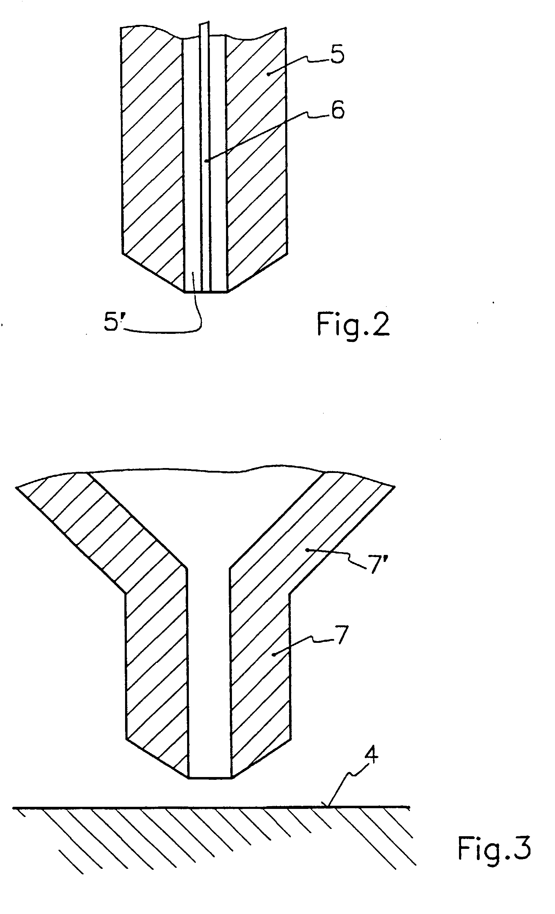

Die Isolierung des Drahtendes kann im ersten Prozeßschritt auch durch Einwirken von thermischer Energie zerstört. Dazu entfällt im ersten Prozeßschritt der erste Anpreßdruck. Der Draht wird in eine spezielle Bondkapillare 5 eingelegt, die einen inneren Durchmesser 5' aufweist und die seitlich geschlitzt ist (Fig. 2). Die Schlitzbreite ist nur geringfügig breiter als der Drahtdurchmesser. Nach dem Einlegen des Drahtes kann der Schlitz 6 verschlossen werden, um den Draht sicher zu halten. Dies geschieht z.B. mit Hilfe einer Hülse, die über die Kapillare 5 geschoben wird oder mittels eines geschlitzten Ringes, der bereits beim Einlegen des Drahtes auf die Kapillare 5 gesteckt ist, wobei der Schlitz im Ring mindestens so breit ist wie derjenige in der Kapillare 5. Nach dem Einlegen des Drahtes wird der Ring so verdreht, daß der Schlitz 6 in der Kapillare 5 durch den Ring verschlossen wird. Ring und Hülse sind in Fig. 2 nicht dargestellt.

Der in der Bondkapillare 5 geführte Draht wird dann mit einer Flamme am unteren, der Kontaktfläche zugewandten Seite angeschmolzen, wobei gleichzeitig der Isolierlack in diesem Drahtbereich vollständig verbrannt wird. Danach folgt der zweite Prozeßschritt wie im ersten Beispiel beschrieben. Da keine Lackreste am angeschmolzenen Drahtende vorhanden sind, können Anpreßkräfte und Ultraschallenergien gegebenenfalls etwas geringer gewählt werden als im ersten Beispiel.

Besonders vorteilhaft ist es, wie in Fig. 3 dargestellt, die Bondkapillare 7 mit einer trichterförmigen Erweiterung 7' am der Kontaktfläche 4 abgewandten Ende zu versehen, was das Einführen von dünnen Drahtanschlüssen erleichtert. Die Drahtenden - z.B. einer Spule - können nacheinander oder simultan eingeführt und angeschmolzen werden. Anschließend folgt das Verbinden mit der Chip-Kontaktfläche z.B. mittels Ultraschall in der oben beschriebenen Weise.

## Patentansprüche

1. Verfahren zum elektrisch leitenden Verbinden von lackisolierten Drahtenden mit Kontaktflächen, wobei ein lackisoliertes Drahtende abisoliert und auf eine Kontaktfläche gepreßt wird und das Drahtende mit elektromagnetischer und/oder akustischer Energie beaufschlagt wird, wobei die Lackschicht des Drahtendes in einem ersten Prozeßschritt mit einem ersten Energieeintrag zerstört und der Draht in einem zweiten Prozeßschritt mit einem zweiten Energieeintrag mit der Kontaktfläche dauerhaft verbunden wird,
**dadurch gekennzeichnet,**
daß die Lackschicht des Drahtendes im ersten Prozeßschritt nur partiell zerstört wird, indem ein Bereich des Drahtendes mit einer ersten Anpreßkraft auf die Kontaktfläche gepreßt und mit dem ersten Energieeintrag beaufschlagt und derselbe Bereich des Drahtendes im zweiten, darauffolgenden Prozeßschritt mit einer zweiten, geringeren Anpreßkraft auf die Kontaktfläche gepreßt und mit dem zweiten Energieeintrag beaufschlagt und mit dieser Kontaktfläche elektrisch leitend verbunden wird.

2. Verfahren nach Anspruch 1,
dadurch gekennzeichnet,
daß die erste Anpreßkraft mehr als 1 N beträgt.

3. Verfahren nach Anspruch 1 oder 2,
dadurch gekennzeichnet,
daß die zweite Anpreßkraft zwischen 0,1 N und 5 N liegt.

4. Verfahren nach einem oder mehreren der vorangegangenen Ansprüche,
dadurch gekennzeichnet,
daß die zweite Anpreßkraft zwischen 0,5 N und 1,5 N liegt.

5. Verfahren nach einem oder mehreren der vorangegangenen Ansprüche,
dadurch gekennzeichnet,
daß das Drahtende mit Ultraschall einer Frequenz oberhalb von 50 kHz beaufschlagt wird.

6. Verfahren nach einem oder mehreren der vorangegangenen Ansprüche,
dadurch gekennzeichnet,
daß die erste Ultraschalleistung im ersten Prozeßschritt mehr als 2,4 Watt beträgt.

7. Verfahren nach einem oder mehreren der vorangegangenen Ansprüche,
dadurch gekennzeichnet,
daß die erste Ultraschalleistung im ersten Prozeßschritt mehr als 3,9 Watt beträgt.

8. Verfahren nach einem oder mehreren der vorangegangenen Ansprüche,
dadurch gekennzeichnet,
daß die erste Ultraschalleistung im ersten Prozeßschritt höchstens 10 Watt beträgt.

9. Verfahren nach einem oder mehreren der vorangegangenen Ansprüche,
dadurch gekennzeichnet,
daß das Drahtende im zweiten Prozeßschritt mit einer zweiten Ultraschalleistung zwischen 1 und 5 Watt beaufschlagt wird.

10. Verfahren nach einem oder mehreren der vorangegangenen Ansprüche,
dadurch gekennzeichnet,
daß das Drahtende im ersten Prozeßschritt mit thermischer Energie beaufschlagt wird.

11. Verfahren nach einem oder mehreren der vorangegangenen Ansprüche
dadurch gekennzeichnet,
daß das Drahtende im ersten Prozeßschritt mit Mikrowellenenergie beaufschlagt wird.

12. Vorrichtung zur Durchführung des Verfahrens zum elektrisch leitenden Verbinden von lackisolierten Drahtenden und Kontaktflächen, wobei die Vorrichtung mindestens eine Energiequelle zur Erzeugung von akustischer und/oder elektromagnetischer Energie, welche in Richtung des Drahtendes abgestrahlt wird, sowie ein Bondwerkzeug enthält, welchem das Drahtende für das Verbinden zugeführt ist, wobei das Bondwerkzeug an der der Kontaktfläche zugewandten Unterseite mit einer konkav geformten, länglichen Einkerbung (2) versehen ist und die Tiefe der Einkerbung geringer als der Drahtdurchmesser ist, insbesondere nach Anspruch 1,
**dadurch gekennzeichnet**,
daß die Einkerbung (2) im Scheitelbereich eine zum Drahtende zugewandte, im wesentlichen länglich geformte konvexe Ausstülpung (2.1) aufweist.

13. Vorrichtung nach Anspruch 12,
dadurch gekennzeichnet,
daß die Höhe der Ausstülpung (2.1) geringer als die Tiefe der Einkerbung (2) ist.

14. Vorrichtung nach Anspruch 12 oder 13,
dadurch gekennzeichnet,
daß das Drahtende beim Beaufschlagen mit thermischer Energie im ersten Prozeßschritt in einer Bondkapillare (5, 7) geführt ist.

15. Vorrichtung nach Anspruch 14,
dadurch gekennzeichnet,
daß die Bondkapillare (5) mit einem seitlichen Schlitz längs der Längsachse der Kapillare versehen ist.

16. Vorrichtung nach Anspruch 15,
dadurch gekennzeichnet,
daß die Breite des vertikalen Schlitzes höchstens 50% breiter als der Durchmesser des Drahtendes ist.

17. Vorrichtung nach Anspruch 15 oder 16,
dadurch gekennzeichnet,
daß die Bondkapillare (7) mit einer trichterförmigen Erweiterung (7') an der der Kontaktfläche abgewandten Seite versehen ist.

18. Vorrichtung nach einem oder mehreren der vorangegangenen Ansprüche 13 bis 17,
dadurch gekennzeichnet,
daß eine Anpreßkraft zwischen Drahtende und Kontaktfläche einstellbar ist.

19. Vorrichtung nach Anspruch 18,
dadurch gekennzeichnet,
daß die Anpreßkraft zwischen Drahtende und Kontaktfläche bis zu 5 N wählbar ist.

20. Vorrichtung nach Anspruch 13,
dadurch gekennzeichnet,
daß eine Energiequelle der Vorrichtung eine Ultraschallquelle ist.

21. Vorrichtung nach Anspruch 20,
dadurch gekennzeichnet,
daß die Leistung der Ultraschallquelle zwischen 0 und 10 Watt wählbar ist.

## Claims

1. Method for electrically conductive connection of lacquer-insulated wire ends with contact surfaces, wherein a lacquer-insulated wire end is deinsulated and pressed against a contact surface and the wire end is loaded with electromagnetic and/or acoustic energy, wherein the lacquer coating of the wire end is destroyed in a first process step by a first feed of energy and the wire is permanently connected with the contact surface in a second process step by a second feed of energy, characterised in that the lacquer coating of the wire end is only partially destroyed in the first process step in that a region of the wire end is pressed against the contact surface by a first pressing force and loaded by the first feed of energy and the same region of the wire end is pressed against the contact surface by a second, smaller pressing force in the second, succeeding process step and loaded by the second feed of energy and is electrically conductively connected with this contact surface.

2. Method according to claim 1, characterised in that the first pressing force amounts to more than 1 N.

3. Method according to claim 1 or 2, characterised in that the second pressing force lies between 0.1 N and 5 N.

4. Method according to one or more of the preceding claims, characterised in that the second pressing force lies between 0.5 N and 1.5 N.

5. Method according to one or more of the preceding claims, characterised in that the wire end is loaded by ultrasound of a frequency above 50 kHz.

6. Method according to one or more of the preceding claims, characterised in that the first ultrasound power in the first process step amounts to more than 2.4 Watts.

7. Method according to one or more of the preceding claims, characterised in that the first ultrasound power in the first process step amounts to more than 3.9 Watts.

8. Method according to one or more of the preceding claims, characterised in that the first ultrasound power in the first process step amounts to at most 10 Watts.

9. Method according to one or more of the preceding claims, characterised in that the wire end in the second process step is loaded by a second ultrasound power between 1 and 5 Watts.

10. Method according to one or more of the preceding claims, characterised in that the wire end in a first process step is loaded with thermal energy.

11. Method according to one or more of the preceding claims, characterised in that the wire end in a first process step is loaded with microwave energy.

12. Device for carrying out the method for electrically conductive connection of lacquer-insulated wire ends and contact surfaces, wherein the device comprises at least one energy source for generation of acoustic and/or electromagnetic energy which is radiated in the direction of the wire end, as well as a bonding tool which is fed to the wire end for the connecting, wherein the bonding tool is provided at the underside facing the contact surface with a concavely shaped, elongate notch (2) and the depth of the notch is less than the diameter of the wire, particularly according to claim 1, characterised in that the notch (2) has in the crest region a substantially elongately shaped convex projection (2.1) facing the wire end.

13. Device according to claim 12, characterised in that the height of the notch (2.1) is less than the depth of the notch (2).

14. Device according to claim 12 or 13, characterised in that the wire end is guided in a bonding capillary (5, 7) during loading with thermal energy in the first process step.

15. Device according to claim 14, characterised in that the bonding capillary (5) is provided with a lateral slot longitudinally of the longitudinal axis of the capillary.

16. Device according to claim 15, characterised in that the width of the vertical slot is at most 50% wider than the diameter of the wire end.

17. Device according to claim 15 or 16, characterised in that the bonding capillary (7) is provided with a funnel-shaped enlargement (7') at the side remote from the contact surface.

18. Device according to one or more of the preceding claims 13 to 17, characterised in that a pressing force between wire end and contact surface is settable.

19. Device according to claim 18, characterised in that the pressing force between wire end and contact surface is selectable up to 5 N.

20. Device according to claim 13, characterised in that an energy source of the device is an ultrasound source.

21. Device according to claim 20, characterised in that the power of the ultrasound source is selectable between 0 and 10 Watts.

## Revendications

1. Procédé pour la liaison électriquement conductrice d'extrémités de fil vernissées avec des faces de contact, où une extrémité de fil vernissée est dévernie et appliquée sur une face de contact et l'extrémité de fil est chargée par une énergie électromagnétique et/ou acoustique, où la couche de vernis de l'extrémité de fil est détruite lors d'une première étape de procédé par un premier apport d'énergie, et le fil est relié durablement lors d'une deuxième étape de procédé, par un deuxième apport d'énergie, à la face de contact,
caractérisé en ce que
la couche de vernis de l'extrémité de fil est détruite lors de la première étape de procédé seulement partiellement en ce qu'une zone de l'extrémité de fil est appliquée par une première force d'application à la face de contact et est sollicitée par le premier apport d'énergie et la même zone de l'extrémité de fil, lors de la deuxième étape de procédé suivante, est appliquée par une deuxième force d'application plus petite à la face de contact et est sollicitée par le deuxième apport d'énergie et est reliée d'une manière électriquement conductrice à cette face de contact.

2. Procédé selon la revendication 1,
caractérisé en ce que
la première force d'application est supérieure à 1 N.

3. Procédé selon la revendication 1 ou 2,
caractérisé en ce que
la deuxième force d'application est comprise entre 0,1 N et 5N.

4. Procédé selon l'une ou plusieurs des revendications précédentes,
caractérisé en ce que
la deuxième force d'application est comprise entre 0,5 N et 1,5 N.

5. Procédé selon l'une ou plusieurs des revendications précédentes,
caractérisé en ce que
extrémité de fil est sollicitée par des ultrasons d'une fréquence supérieure à 50 kHz.

6. Procédé selon l'une ou plusieurs des revendications précédentes,
caractérisé en ce que
la première puissance ultrasonore, lors de la première étape de procédé est supérieure à 2,4 watts.

7. Procédé selon l'une ou plusieurs des revendications précédentes,
caractérisé en ce que
la première puissance ultrasonore, lors de la première étape de procédé, est supérieure à 3,9 watts.

8. Procédé selon l'une ou plusieurs des revendications précédentes,
caractérisé en ce que
la première puissance ultrasonore, lors de la première étape de procédé, est au maximum de 10 watts.

9. Procédé selon l'une ou plusieurs des revendications précédentes,
caractérisé en ce que
l'extrémité de fil est sollicitée lors de la deuxième étape de procédé par une deuxième puissance ultrasonore entre 1 et 5 watts.

10. Procédé selon l'une ou plusieurs des revendications précédentes,
caractérisé en ce que
l'extrémité de fil est sollicitée lors de la première étape de procédé par de l'énergie thermique.

11. Procédé selon l'une ou plusieurs des revendications précédentes,
caractérisé en ce que
l'extrémité de fil, lors de la première étape de procédé, est sollicitée par de l'énergie hyperfréquence.

12. Dispositif pour la mise en oeuvre du procédé pour la liaison électriquement conductrice d'extrémités de fil vernissées et de faces de contact, où le dispositif comporte au moins une source d'énergie pour produire de l'énergie acoustique et/ou électromagnétique qui est rayonnée en direction de l'extrémité du fil, ainsi qu'un outil à souder auquel est amenée l'extrémité de fil en vue de la liaison, où l'outil à souder présente au côté inférieur orienté vers la face de contact une encoche oblongue (2) de forme concave, et la profondeur de l'encoche est plus petite que le diamètre du fil, notamment selon la revendication 1,
caractérisé en ce que
l'encoche (2) présente dans la zone de sommet une protubérance convexe (2.1) de forme sensiblement allongée, orientée vers l'extrémité de fil.

13. Dispositif selon la revendication 12,
caractérisé en ce que
la hauteur de la protubérance (2.1) est plus petite que la profondeur de l'encoche (2).

14. Dispositif selon la revendication 12 ou 13,
caractérisé en ce que
l'extrémité de fil, lors de la sollicitation par de l'énergie thermique pendant la première étape de procédé, est guidée dans un tube capillaire à souder (5, 7).

15. Dispositif selon la revendication 14,
caractérisé en ce que
le tube capillaire à souder (5) présente une fente latérale le long de l'axe longitudinal du tube capillaire.

16. Dispositif selon la revendication 15,
caractérisé en ce que
la largeur de la fente verticale est au plus 50% plus large que le diamètre de l'extrémité de fil.

17. Dispositif selon la revendication 15 ou 16,
caractérisé en ce que
le tube capillaire à souder (7) présente un élargissement en forme d'entonnoir (7') au côté éloigné de la face de contact.

18. Dispositif selon l'une ou plusieurs des revendications précédentes 13 à 17,
caractérisé en ce qu'
une force d'application entre l'extrémité de fil et la face de contact est réglable.

19. Dispositif selon la revendication 18,
caractérisé en ce que
la force d'application entre l'extrémité de fil et la face de contact peut être choisie jusqu'à 5 N.

20. Dispositif selon la revendication 13,
caractérisé en ce qu'
une source d'ultrasons constitue une source d'énergie du dispositif.

21. Dispositif selon la revendication 20,
caractérisé en ce que
la puissance de la source d'ultrasons peut être choisie entre 0 et 10 watts.
